Europäisches Patentamt

European Patent Office

Office européen des brevets

(11) Numéro de publication: **0 206 851 B1**

# FASCICULE DE BREVET EUROPEEN

(45) Date de publication de fascicule du brevet:
**08.05.91**

(51) Int. Cl.⁵: **H01S 3/19**, H01L 33/00

(21) Numéro de dépôt: **86401019.4**

(22) Date de dépôt: **13.05.86**

(54) **Procédé de réalisation de lasers à semiconducteurs à jonctions bloquantes assurant un confinement électrique.**

(30) Priorité: **13.05.85 FR 8507210**

(43) Date de publication de la demande:
**30.12.86 Bulletin 86/52**

(45) Mention de la délivrance du brevet:
**08.05.91 Bulletin 91/19**

(84) Etats contractants désignés:
**DE FR GB**

(56) Documents cités:
**EP-A- 0 025 749**
**EP-A- 0 083 697**
**FR-A- 2 440 616**
**US-A- 4 230 997**
**US-A- 4 429 397**

**JOURNAL OF APPLIED PHYSICS, vol. 53, no. 4, avril 1982, pages 2851-2853, American Institute of Physics, New York, US; H. ISHIKAWA et al.: "V-grooved substrate buried heterostructure InGaAsP/InP laser by one-step epitaxy"**

**IEEE JOURNAL OF QUANTUM ELECTRONICS, vol. QE-17, no. 5, mai 1981, pages 640-645,**

**IEEE, New York, US; S. ARAI et al.: "1.6 Mum wavelength GaInAsP/InP BH lasers"**

(73) Titulaire: **Devoldere, Pascal**
**26, rue Antoine Fratacci**
**F-92170 Vanves(FR)**

Titulaire: **Gilleron, Marc**
**94, Boulevard Poniatowski**
**F-75012 Paris(FR)**

(72) Inventeur: **Devoldere, Pascal**
**26, rue Antoine Fratacci**
**F-92170 Vanves(FR)**
Inventeur: **Gilleron, Marc**
**94, Boulevard Poniatowski**
**F-75012 Paris(FR)**

(74) Mandataire: **Mongrédien, André et al**
**c/o BREVATOME 25, rue de Ponthieu**
**F-75008 Paris(FR)**

## Description

Le domaine technique de l'invention est celui des lasers à semi-conducteurs et à géométrie à ruban. L'une des principales applications de ces lasers est d'être utilisés comme émetteur de lumière dans les télécommunications par fibres optiques. En particulier pour les liaisons optiques à haut débit et à longue distance, ces lasers doivent posséder un certain nombre de caractéristiques : faible courant de seuil, puissance optique émise d'une dizaine à quelques dizaines de milliwatts, fonctionnement stable sur le mode fondamental transverse, bonne linéarité de la caractéristique puissance-courant au-dessus du seuil, grande bande passante etc...

Pour remplir ces conditions, la recombinaison des électrons et des trous assurant l'émission laser doit s'opérer dans une région, dite région active, où les porteurs (électrons et trous) et l'émission lumineuse sont confinés. Le type général de lasers répondant à ces critères est dénommée "laser enterré". Dans ce type de laser, le matériau semiconducteur constituant la zone active est entouré d'un matériau de plus faible indice de réfraction, ce qui permet d'assurer le confinement optique du faisceau laser, et de plus grande bande interdite, ce qui permet d'assurer le confinement électrique des porteurs injectés dans la région active. Pour parfaire ce confinement électrique, il est, de plus, nécessaire de guider les porteurs depuis les contacts métalliques jusque dans la région active. Ce guidage est en général assuré par une ou plusieurs jonctions p-n polarisées en inverse, réalisées dans le matériau semiconducteur de grande bande interdite entourant la région active et positionnées de part et d'autre de cette région active.

Pour bien comprendre le procédé de l'invention il est nécessaire d'exposer quelques procédés de réalisation de lasers de ce type.

Depuis quelques années, un grand nombre de structures de type "laser enterré" ont été décrites dans la littérature, que ce soit pour l'émission à 0,85µm (laser GaAs-GaAlAs) ou pour l'émission à 1,3 et 1,55µm (laser InP-GaInAsP). Ces différentes structures peuvent être classées en deux grandes familles :

- celles qui sont réalisées en un seul cycle d'épitaxie liquide à partir d'un substrat gravé (gravure de sillons ou de mésas),
- celles qui sont réalisées en deux cycles d'épitaxie (reprise d'épitaxie liquide ou vapeur sur une mésa gravée dans la première épitaxie obtenue par croissance en phase liquide ou vapeur).

Dans la première famille des structures obtenues en un seul cycle d'épitaxie liquide, on peut distinguer tout d'abord les structures obtenues à partir de sillons gravés dans le substrat avant épitaxie.

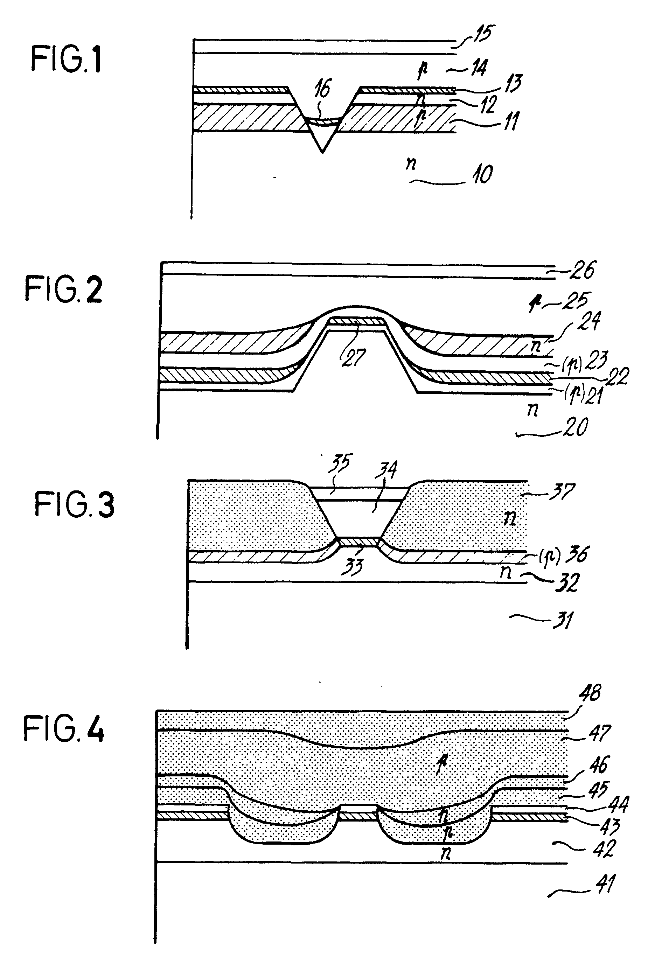

Les meilleurs résultats obtenus avec cette structure ont été publiés par H. ISHIKAWA et al. dans la revue J. Appl. Phys. 53(4), 1982, p.2851. Il s'agit de lasers InP-InGaAsP̄ émettant à 1,3µm. Les propriétés de l'épitaxie en phase liquide font que la couche active en InGaAsP ne croît pas sur les plans cristallographiques formant les flancs du sillon. On obtient ainsi une croissance séparée de cette couche dans le fond du sillon d'une part et sur les parties planes non gravées d'autre part. Cette structure a été "baptisée" "V-groove Substrate Buried Heterostructure" (en abrégé V.S.B.). Elle est illustrée sur la figure 1 annexée.

La structure comprend des couches 10 à 16 dont la composition est la suivante :
15 : couche de contact InGaAsP de type p
14 : couche de confinement InP de type p
13 et 16 : couche InGaAsP
12 : couche de confinement InP de type n
11 : couche InP de type p obtenue par diffusion dans le substrat
10 : substrat InP de type n.

La région active 16 se trouve ainsi enterrée par la première couche de confinement 12 en InP de type n, en-dessous, par le substrat dopé p, sur les côtés (11), et par la couche de confinement InP de type p 14, au-dessus. Le blocage du courant de part et d'autre de la région active est obtenu par la succession de couches n-p-n-p dont l'une (la couche référencée 11 sur la figure 1) est obtenue par diffusion d'un dopant p (zinc ou cadmium) dans le substrat avant gravure des sillons.

Les caractéristiques obtenues avec cette structure laser sont : un courant de seuil en un régime continu compris entre 10 et 20 mA, un fonctionnement en continu jusqu'à 100 C, une puissance optique maximale de 30 mW à la température ambiante, dont 20 mW sur le mode fondamental transverse, et une bande passante d'environ 4GHz.

Toujours dans la première famille, on distingue encore les structures obtenues à partir de mésas gravées dans le substrat avant épitaxie.

Très peu de structures de ce type ont été décrites dans la littérature. Les meilleurs résultats ont été obtenus par H. NOMURA et al., selon la communication présentée la "Fifth Topical Meeting on Optical Fibers", Phoenix, Avril 1982. Ces résultats concernent des lasers InP-InGaAsP émettant à 1,3µm. Ces auteurs ont baptisé cette structure "Current Confinement Mesa Substrate-Buried Heterostructure" (en abrégé C.C.M.). Elle est schématiquement représentée sur la figure 2.

Les différentes couches représentées ont la composition suivante :
26 : couche de contact en InGaAsP de type p
25 : deuxième couche de confinement en InP de type p

24 : couche de blocage en InP de type n

23 : première couche de confinement en InP de type p

22 et 27 : couche en InGaAsP

21 : couche de confinement en InP de type p 20 : substrat en InP de type $n^+$.

Comme pour la structure précédemment décrite (structure laser VSB), l'épitaxie en phase liquide permet une croissance séparée de la couche en InGaAsP, sur le sommet de la mésa d'une part 27 et sur les parties planes du substrat d'autre part 22. Dans cette structure, la succession de couches en InP de type p-n-p-n est obtenue en intercalant, au cours du cycle d'épitaxie, entre deux couches de confinement en InP de type p 22 et 25, une couche de blocage en InP de type n 24. NOMURA et al. affirment, dans leur communication, qu'il est possible de faire croîte cette couche 24 de part et d'autre de la région active enterrée 27, mais pas sur le sommet de la mésa, en utilisant, pour cette croissance, un bain liquide très faiblement sursaturé.

Avec cette structure, le meilleur courant de seuil obtenu est de 16 mA. Le laser peut fonctionner en régime continu jusqu'à 125°C. La puissance maximale obtenue à 30°C en régime continu est proche de 70 mW dont à peu près 20 mW sur le mode fondamental transverse. Aucune valeur n'a été publiée concernant la bande passante.

Dans la seconde famille des structures lasers obtenues en deux cycles d'épitaxie, on peut distinguer tout d'abord la structure la plus connue et la plus ancienne des structures type lasers enterrés et qui est appelée B.H. (pour "Buried Heterostructure"). Dans une première épitaxie on réalise une double hétérostructure (D.H.) classique ; par exemple, pour les lasers émettant à 1,3$\mu$m, on fait croître successivement une couche InP de type n, une couche active en InGaAsP, une couche InP de type p et une couche de contact en InGaAsP de type $p^+$. On réalise ensuite dans cette double hétérostructure, généralement par attaque chimique, des rubans ayant la forme de mésas inversées et ce, jusqu'à la couche InP de type n. Lors de la deuxième épitaxie, on fait croître successivement une couche InP de type p et une couche InP de type n de part et d'autre de la mésa protégée par un masque diélectrique. Ces deux couches forment les jonctions bloquantes.

Cette structure est schématiquement représentée sur la figure 3 annexée. Elle comprend les couches suivantes :

31 : substrat en InP

32 : couche en InP de type n

33 : couche active en InGaAsP

34 : couche en InP type p

35 : couche en InGaAsP de type $p^+$

36 : couche en InP de type p

37 : couche en InP de type $n^+$.

Pour cette structure, les meilleurs courants de seuil publiés à 1,3 $\mu$m sont autour de 10 mA. Par contre, la puissance maximale obtenue en régime continu est relativement faible : 20 à 30 mW. La température maximale de fonctionnement en continu est de 80 à 100°C, la bande passante est comprise entre 3 et 4 GHz.

A titre d'exemples, on peut citer deux publications concernant ces structures : l'une de M. HIRAO et al., dans J. Appl. Phys. 51(8); p.4539 (1980) et l'autre de S.ARAI et al., IEEE dans J. of Quant. Elect. QE-1715), p.640 1981).

Toujours dans la seconde famille des structures obtenues en deux cycles d'épitaxie on peut distinguer la structure baptisée DC-PBH pour "Double-Channel Planar Buried Heterostructure".

Selon cette technique une double hétérostructure classique est d'abord réalisée au cours d'une première épitaxie (par exemple à l'aide de InP n, InGaAsP, InP p sans couche de contact). Comme pour la structure enterrée BH, des rubans ayant la forme de mésas sont ensuite définis dans cette double hétérostructure. La différence avec la structure précédente réside dans le fait que ces mésas sont bordées de chaque côté par un "canal". La deuxième épitaxie permet la croissance de quatre couches successives InP p, InP n, InP p, couche de contact en InGaAsP $p^+$, sans protection de la mésa à l'aide d'une couche diélectrique durant cette croissance ; c'est la différence essentielle avec la structure enterrée.

La structure est représentée sur la figure 4. Elle comprend les couches suivantes :

48 : couche de contact InGaAsP $p^+$

47 : deuxième couche de confinement InP p

46 : couche bloquante InP n

45 : couche bloquante InP p

44 : première couche de confinement InP p

43 : couche en InGaAsP

42 : couche de confinement InP n

41 : substrat en InP de type $n^+$.

Les couches 42 à 44 sont déposées lors de la première épitaxie et les couches 45 à 48 lors de la seconde.

Une telle structure est décrite dans l'article de I. MITO et al., dans IEEE J. of Lightwave Technol., LT1, p195 (1983). D'après les auteurs, le cycle d'épitaxie liquide utilisé permet de limiter la croissance des deux premières couches InP p et InP n (dites couches bloquantes 45 et 46) de la seconde épitaxie aux régions situées de part et d'autre de la mésa. Les deux autres couches, InP p (couche de confinement 44) et InGaAsP $p^+$ (couchede contact 48) recouvrant ensuite l'ensemble de la structure qui devient ainsi de type planar. Cette technique de croissance a l'avantage d'aligner automatiquement la jonction bloquante n-p dans l'InP de part et d'autre de la mésa avec la région active enterrée, ce qui n'est pas le cas dans la structure enterrée BH où cet alignement est particulièrement délicat.

Du point de vue des caractéristiques, cette structure enterrée se place très certainement parmi les meilleures : courant de seuil de l'ordre de 20 mA (valeur la plus faible, 10 mA), fonctionnement sur le mode fondamental transverse jusqu'à 50 mW, fonctionnement en régime continu jusqu'à 130°C. De plus, ces lasers montrent une très bonne stabilité dans le temps (plus de 6000 h à 50°C-20mW sans dégradations). Les articles publiés sur cette structure ne donnent, par contre, aucune caractéristique concernant la bande passante.

Toutes ces techniques, si elles conviennent bien à certains égards, présentent néanmoins certains inconvénients.

En ce qui concerne la première famille des structures réalisées en un cycle d'épitaxie, les inconvénients sont les suivants.

Pour ce qui est tout d'abord de la structure VSB, bien que présentant l'intérêt d'être réalisée en un seul cycle d'épitaxie, cette structure ne permet pas la fabrication de lasers à réseau type DFB. En effet, le fond du sillon n'étant pas plan, il est impossible d'y graver un réseau avant l'épitaxie.

Un autre inconvénient de cette structure est la plus faible efficacité (comparativement aux autres structures) des jonctions bloquantes p-n-p-n. Ceci résulterait de la faible épaisseur (environ $0,3\mu m$) de la première couche épitaxiée (couche de confinement InP n référencée 12 sur la figure 1). L'épaisseur de cette couche ne peut être augmentée, car elle contrôle simultanément la position verticale (très critique) de la région active 16 dans le sillon. Cette moindre efficacité des couches bloquantes pourrait expliquer la plus faible puissance optique maximale obtenue (30 mW contre 50 à 70mW obtenus avec les autres structures décrites).

Pour ce qui est de la structure CCM, la croissance de la couche bloquante 24 de type n (voir figure 2) pose un problème de reproductibilité, le contrôle précis du degré de sursaturation d'un bain en épitaxie liquide étant, en effet, délicat.

En ce qui concerne maintenant la seconde famille des structures réalisées en deux cycles d'épitaxie, l'inconvénient majeur est leur complexité d'élaboration liée à l'utilisation de ces deux cycles. Cette complexité conduit à un faible rendement de fabrication et à un coût élevé. De plus, la réalisation de lasers plus sophistiqués tels que les lasers à réseau du type DFB (Distributed Feedback Laser) avec une structure ruban enterré du type DC.PBH nécessitent trois cycles d'épitaxie (cf. l'article de KITAMURA et al. publié dans Electr. Letters vol.19 n°20, p.840, Sept.1983), ce qui augmente d'autant la complexité de fabrication.

Le but de l'invention est justement de remédier à ces inconvénients. L'invention consiste en un procédé simple de réalisation de couches bloquantes p-n-p-n ou d'une couche isolante assurant le confinement électrique dans un laser à semiconducteur du type enterré. Cette technique présente comme principal intérêt d'être compatible avec la fabrication de lasers à région active enterrée, y compris les lasers à réseau (type DFB) en un seul cycle d'épitaxie. Plus précisément, ce procédé de réalisation des couches bloquantes ou isolante permet d'aboutir à une structure laser proche de la structure CCM précédemment décrite, tout en évitant le contrôle délicat de la sursaturation d'un bain d'épitaxie liquide comme c'est le cas pour cette structure.

Le procédé de réalisation objet de l'invention, peut également être compatible avec des structures lasers enterrées réalisées en deux cycles d'épitaxie.

Le laser obtenu par le procédé de l'invention est un laser à semiconducteurs dont la région active est enterrée et dont le guidage des porteurs, depuis les contacts métalliques jusqu'à la région active, est assuré par l'effet de couches semiconductrices p-n-p-n bloquantes ou par la présence d'une couche isolante, situées de part et d'autre de la région active enterrée, ces couches étant autoalignées avec la région active.

Trois moyens essentiels caractérisent l'invention :

- une gravure permettant de définir des reliefs sur un substrat ou une couche épitaxiée, en l'occurrence des rubans ayant un profil en forme de mésa,
- une épitaxie en phase liquide,
- une technique de diffusion ou d'implantation ionique d'un dopant p ou d'une impureté rendant le matériau semi-isolant dans un substrat ou une couche de type n (le substrat peut être de type p dans le cas de l'implantation d'une impureté "semi-isolante").

L'invention repose essentiellement sur l'association de la diffusion ou de l'implantation qui, pour un matériau donné, est isotrope et de l'épitaxie en phase liquide qui, au contraire, conduit à une croissance anisotrope sur un substrat (ou une couche) sur lequel a été défini un relief. En effet, l'épitaxie en phase liquide permet, d'une part, une croissance localisée (par exemple sur le sommet d'une mésa ou dans le fond d'un sillon), et d'autre part, d'aboutir à une surface plane à partir d'un substrat avec relief. Les autres techniques d'épitaxie (phase vapeur par organo-métalliques ou jets moléculaires) ne possèdent pas ces propriétés.

De toute façon les caractéristiques de l'invention apparaîtront mieux après la description qui suit de deux exemples de réalisation. Cette description se refère à des dessins annexés sur lesquels :

- la figure 1, déjà décrite, est une coupe schématique d'un laser enterré InP-InGaAsP obtenu par épitaxie liquide dans un sillon gravé dans un substrat d'InP (structure VSB) ;
- la figure 2, déjà décrite, est une coupe schématique d'un laser enterré InP-InGaAsP obtenu par épitaxie liquide sur une mésa gravée dans un substrat d'InP (structure CCM) ;
- la figure 3, déjà décrite, est une coupe schématique d'un laser enterré InP-InGaAsP obtenu en deux cycles d'épitaxie (structure BH) ;
- la figure 4, déjà décrite est une coupe schématique d'une structure laser enterrée InP-InGaAsP (structure DC-PBH) ;
- la figure 5 montre diverses étapes du procédé selon l'invention.

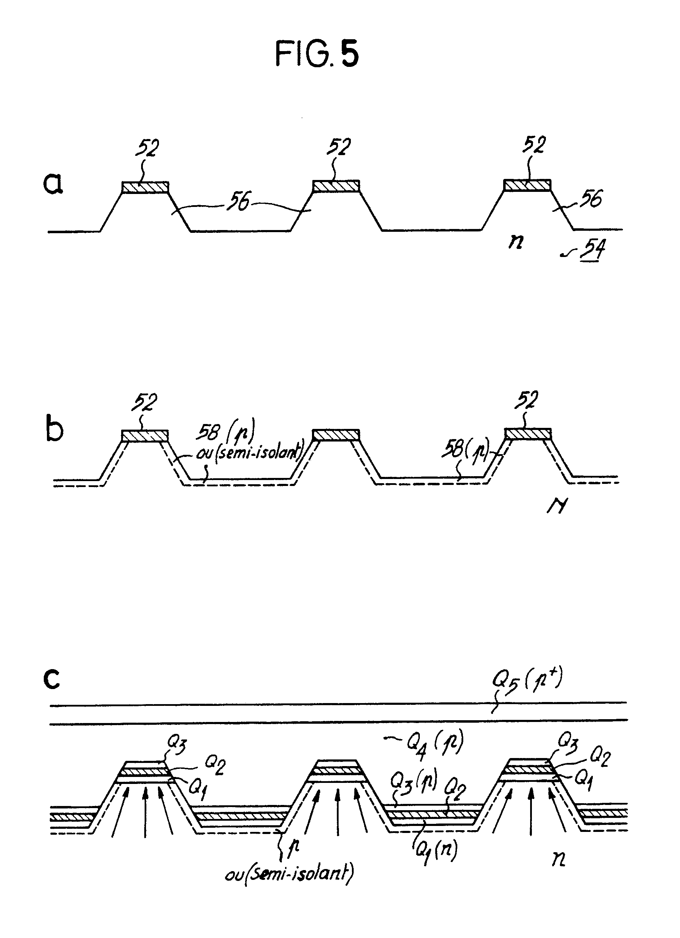

La figure 5 illustre un procédé de réalisation conforme à l'invention. On a la suite des opérations suivantes :

1. Gravure de rubans ayant un profil en forme de mésas (figure 5 partie a) : des rubans 52 en matériau diélectrique (par exemple $Si_3N_4$) sont formés à la surface d'un substrat 54 en InP de type $n^+$ ; ces rubans ont une largeur de quelques microns (2 à 10 $\mu$m) ; en dehors des régions protégées par ces rubans qui constituent un masque, le substrat 54 est attaqué à l'aide d'une solution chimique appropriée et l'on obtient des mésas 56 ; ces mésas ont une largeur au sommet et une hauteur de quelques microns (typiquement 2 $\mu$m) ; l'attaque chimique peut être remplacée par une autre technique de gravure ; un usinage ionique ou une gravure ionique réactive (R.I.E.) par exemple ; le profil des mésas obtenues dépend à la fois de la direction cristallographique suivant laquelle les rubans sont alignés, de la nature du masque utilisé, de la technique et des conditions de gravure utilisées.

2. Implantation d'un dopant de type p (figure 5, partie b) : l'implantation est réalisée en conservant le masque constitué par les rubans 52 ; on forme ainsi, sur les flancs et de part et d'autre des mésas, une couche de type p référencée 58 sur la partie b de la figure 5 et, par conséquent, une jonction pn avec le substrat qui est de type $n^+$ ; l'ion dopant p peut être remplacé par un ion rendant le matériau semi-isolant (par exemple le fer dans le cas d'un substrat en InP).

3. Epitaxie en phase liquide d'une double hétérostructure InP-InGaAsP (figure 5, partie c) : dans le cas d'une émission à 1,55 $\mu$m, la succession des couches est la suivante :

- une couche $Q_1$ en InGaAsP ($\lambda$g d'environ 1,3 $\mu$m) où $\lambda$g est la longueur d'onde correspondant à l'énergie de la bande interdite du matériau considéré ; cette couche sert de tampon ; elle est dopée n ; son épaisseur est de 0,10 $\mu$m ; cette couche croît séparément sur le sommet des mésas et dans le fond plat des intervalles séparant les mésas mais pas sur les flancs obliques de celle-ci ;
- une couche active $Q_2$ en InGaAsP ($\lambda$g d'environ 1,55 $\mu$m) non intentionnellement dopée, d'épaisseur environ 0,2 $\mu$m ; la croissance de cette couche est identique à celle de la couche précédente ;
- une couche $Q_3$ en InGaAsP ($\lambda$g d'environ 1,3 $\mu$m) non dopée ou dopée p ; cette couche est appelée couche antiredissolution ; son épaisseur est d'environ 0,1 $\mu$m ; sa croissance est la même que celle des deux couches précédentes.

4. Epitaxie en phase liquide de deux couches supplémentaires :

- une couche $Q_4$ en InP de type p, dite de confinement, la croissance se fait uniformément sur toute la surface ; l'épaisseur de cette couche doit être suffisante pour combler les intervalles séparant les mésas et obtenir une surface supérieure plane ; elle est de 3 à 5$\mu$m suivant la hauteur des mésas ;
- une couche $Q_5$ en InGaAsP ($\lambda$g d'environ 1,2 $\mu$m) dopée $p^+$ et appelée couche de contact.

La structure finalement obtenue est représentée en coupe sur la figure 5, partie c.

De part et d'autre des mésas, on trouve un empilement de couches n-p-n-p qui bloquent les porteurs et les guident vers le sommet des mésas, c'est-à-dire vers la couche active $Q_2$.

Dans ce qui précède le terme "substrat" doit être compris comme signifiant soit un corps massif constitué d'un matériau unique, soit d'une structure formée de plusieurs couches empilées, obtenues par exemple par épitaxie.

## Revendications

1. Procédé de réalisation de lasers à semiconducteurs comprenant la suite des opérations suivantes :

   a) dépôt sur un substrat (54) en InP de type $n^+$ d'un masque diélectrique en forme de rubans (52),

   b) gravure du substrat (54) à travers ce masque pour obtenir des mésas (56) à sommet plat et à flancs obliques, ces mésas étant séparées par des intervalles à fond plat,

c) implantation soit d'un dopant de type p à travers le masque (52) utilisé pour la gravure des mésas, ce qui donne naissance à une couche (58) de type p sur les flancs des mésas et sur les parties planes situées entre les mésas et crée ainsi une première jonction pn sur toute la structure à l'exception du sommet des mésas, soit d'une impureté rendant le matériau du substrat (54) semi-isolant à travers ledit masque (52) ce qui donne naissance à une couche (58) semi-isolante sur les flancs des mésas et sur les parties planes situées entre les mésas,

d) élimination du masque (52),

e) épitaxie en phase liquide d'une double hétérostructure comprenant trois couches croissant sur le sommet des mésas et sur les parties planes des intervalles séparant les mésas mais non sur les flancs obliques des mésas, ces trois couches comprenant :
- une couche $Q_1$ en InGaAsP dopée $n^+$ servant de couche tampon,
- une couche $Q_2$ en InGaAsP non dopée, constituant la région active,
- une couche $Q_3$ en InGaAsP non dopée ou dopée p,

f) épitaxie en phase liquide d'une quatrième couche $Q_4$ en InP de type p, dite de confinement d'épaisseur suffisamment grande pour que l'intervalle séparant les mésas soit comblé et que la surface supérieure de la couche obtenue $Q_4$ soit plane,

g) dépôt d'une cinquième couche $Q_5$ en InGaAsP dopée $p^+$ constituant une couche de contact.

## Claims

1. Process for producing semiconductor lasers comprising the sequence of the following operations:

a) deposition of a dielectric mask in the form of strips (52) onto a substrate (54) made of InP of $m^{+-}=$ type,

b) etching of the substrate (54) through this mask to obtain flat-topped mesas (56) with sloping flanks, these mesas being separated by flat-bottomed intervals,

c) implantation either of a p-type dopant through the mask (52) employed for etching the mesas, which gives rise to a p-type layer (58) on the flanks of the mesas and on the flat parts situated between the mesas and thus creates a first pn junction over the whole structure with the exception of the top of the mesas, or of an impurity making the material of the substrate (54) semiinsulating through the said mask (52), which gives rise to a semiinsulating layer (58) on the flanks of the mesas and on the flat parts situated between the mesas,

d) removal of the mask (52),

e) epitaxy in liquid phase of a double heterostructure comprising three layers growing on the top of the mesas and on the flat parts of the intervals separating the mesas but not on the sloping flanks of the mesas, these three layers comprising:
- a layer $Q_1$ made of $M^{+-}=$ doped InGaAsP serving as a buffer layer,
- a layer $Q_2$ made of undoped InGaAsP, constituting the active region,
- a layer $Q_3$ made of undoped or p-doped InGaAsP,

f) epitaxy in liquid phase of a fourth layer $Q_4$ made of p-type InP, so-called confinement layer, of sufficiently great thickness for the interval separating the mesas to be filled in and for the upper surface of the layer obtained $Q_4$ to be planar,

g) deposition of a fifth layer $Q_5$ made of $p^{+-}=$ doped InGaAsP constituting a contact layer.

## Ansprüche

1. Verfahren zur Herstellung eines Halbleiterlasers, welches die folgenden Verfahrensschritte umfaßt:

(a) Aufbringen einer dielektrischen Maske in Form von Bändern (52) auf ein InP-Substrat (54) des $n^+$-Typs;

(b) Ätzen des Substrats (54) quer über der Maske, um tafelberg-bzw. mésa-ähnliche Erhebungen (56) mit flachem Gipfel und schrägen Flanken zu erhalten, wobei diese tafelbergähnlichen Erhebungen durch Zwischenräume mit ebenem Boden getrennt sind,

(c) Implantieren entweder von einem p-Tpy-Dotierungsmittel quer über der für das Ätzen der tafelbergähnlichen Erhebungen verwendeten Maske (52), was zur Bildung einer p-Schicht (58) auf den Flanken der tafelbergähnlichen Erhebungen und auf den zwischen diesen tafelbergähnlichen Erhebungen liegenden ebenen Bereichen führt und eine erste pn-Grenzschicht auf dem gesamten Gebilde mit Ausnahme der Gipfel der tafelbergähnlichen Erhebungen schafft, oder eines Fremdatoms, das das Substratmatrial (64) halb-isolierend macht, quer über der Maske (52), was zu einer halb-isolierenden Schicht (58) auf den Flanken der tafelbergähnlichen Erhebungen und den zwischen
diesen tafelbergähnlichen Erhebungen befindlichen ebenen Bereichen führt,

(d) Entfernen der Maske (52),

(e) Flüssigphasen-Epitaxie von einer
Zweifach-Heterostruktur mit drei Schichten,
die sich auf den Gipfeln der tafelbergähnlichen Erhebungen und auf den ebenen Bereichen der die tafelbergähnlichen Erhebungen trennenden Zwischenräume, aber nicht
auf den schrägen Flanken der tafelbergähnlichen Erhebungen kreuzen, wobei die drei
Schichten aufweisen:

  - eine $n^+$-dotierte InGaAsP-Schicht Q1,
    die als Pufferschicht dient,
  - eine nicht dotierte InGaAsP-Schicht
    Q2, die den aktiven Bereich darstellt,
  - eine nicht oder p-dotierte InGaAsP-
    Schicht Q3,

(f) Flüssigphasen-Epitaxie einer vierten InP-
Schicht Q4 des p-Typs, und zwar als Endschicht mit ausreichender Dicke, damit der
die tafelbergähnlichen Erhebungen trennende Zwischenraum ausgefüllt wird und die
obere Fläche der erhaltenen Schicht Q4
eben ist,

(g) Aufbringen einer fünften $p^+$-dotierten
InGaAsP-Schicht Q5, die eine Kontakt-
schicht bildet.

FIG.1

FIG.2

FIG.3

FIG.4

# FIG.5